# EUROPÄISCHE PATENTSCHRIFT

(11) **EP 3 728 772 B1**
(45) Veröffentlichungstag und Bekanntmachung des Hinweises auf die Patenterteilung: **15.09.2021**
(21) Anmeldenummer: 18822294.7
(22) Anmeldetag: 10.12.2018
(51) Int. Cl.: E05B 85/16, E05B 81/76, E05B 85/10, E05B 17/00, E05B 81/54

(54) **FAHRZEUGTÜRGRIFF**
VEHICLE DOOR HANDLE
POIGNÉE DE PORTIÈRE DE VÉHICULE

(30) Priorität: 21.12.2017 DE 102017130876
(43) Veröffentlichungstag der Anmeldung: 28.10.2020
(73) Patentinhaber: Huf Hülsbeck & Fürst GmbH & Co. KG, 42551 Velbert (DE)
(72) Erfinder: REIFENBERG, Bernd, 45259 Essen (DE); BEXTERMÖLLER, Hubert, 45468 Mühlheim a.d.R. (DE); BEHMENBURG, Dominik, 40789 Monheim am Rhein (DE); RHEIN, Michael, 41199 Mönchengladbach (DE)
(86) Internationale Anmeldenummer: PCT/EP2018/084119
(87) Internationale Veröffentlichungsnummer: WO 2019/121090

(56) Entgegenhaltungen:
- EP-A1- 1 975 349
- EP-A2- 2 412 897
- EP-A2- 2 607 581
- WO-A1-2018/041442

## Beschreibung

Die Erfindung betrifft einen Fahrzeugtürgriff für Türen oder Klappen von Kraftfahrzeugen nach dem Oberbegriff des Anspruchs 1. Der Fahrzeugtürgriff weist ein Griffgehäuse auf, welches aus wenigstens zwei Schalenbauteilen gebildet ist. Wenigstens eine Platine ist in dem Griffgehäuse aufgenommen und mit elektronischen Bauteilen bestückt. Die elektrischen Komponenten können insbesondere Sensoren, Schalter, Antennen und Kommunikationsschaltungen aufweisen. Am Fahrzeugtürgriff ist ein Steckverbinder gekoppelt, der zur Kontaktierung der Platine und der darauf angeordneten elektronischen Bauteile vorgesehen ist und außerhalb des Gehäuses angeordnet ist, um eine elektrische Schnittstelle für einen fahrzeugseitigen korrespondierenden Stecker bereitzustellen. Der Steckverbinder weist eine Mehrzahl von Kontakten auf, die ihrerseits mit elektrischen Leitungen gekoppelt sind, wobei die Leitungen sich von den Kontakten des Steckverbinders durch den Griff ins Innere bis zur Platine erstrecken.

Fahrzeugtürgriffe der genannten Art werden bei Fahrzeugen eingesetzt, um mechanische Handhaben zur Betätigung einer Tür oder Klappe und auch Kommunikationsfunktionen und/oder Schaltfunktionen zur Verfügung zu stellen.

Beispielsweise offenbart die EP 2 607 581 A2 einen Fahrzeugtürgriff der eingangs genannten Art. Bei diesem Fahrzeugtürgriff sind Elektronikkomponenten in einem mehrschalig aufgebauten Griffgehäuse mit einer Vergussmasse eingebettet. Ein Steckverbinder ist außerhalb des Griffgehäuses zugänglich angeordnet, um die elektronischen Komponenten innerhalb des Gehäuses mit einem fahrzeugseitigen elektronischen Steuersystem zu koppeln.

Kraftfahrzeugtürgriffe der genannten Art sind aufwendig in Fertigung und Montage. Die flexiblen Leitungskomponenten zwischen Steckverbinder und Platine erschweren eine Ausrichtung der Komponenten innerhalb des Türgriffes und die Anordnung der Leitungen im Griff.

Die EP1975349, EP2412897A2, EP2607581A2, WO2018041442A1 zeigen einen gattungsgemäßen Fahrzeugtürgriff.

Aufgabe der Erfindung ist es, ein kostengünstiges und einfach zu montierendes Fahrzeugtürgriffsystem zur Verfügung zu stellen.

Diese Aufgabe wird durch einen Fahrzeugtürgriff mit den Merkmalen des Patentanspruches 1 gelöst.

Der erfindungsgemäße Fahrzeugtürgriff zeichnet sich dadurch aus, dass die Platine mit den elektronischen Bauteilen auf einem Träger in dem Griffgehäuse angeordnet und fixiert ist, wobei der Träger mit dem Steckverbinder als Spritzgussteil einteilig ausgebildet ist. Die Platine ist also nicht durch flexible Kabelverbindungen mit dem Steckverbinder gekoppelt, sondern der Stecker ist gemeinsam mit dem Träger als durchgehendes Spritzgussteil integral gefertigt. Der Steckverbinder kann entsprechend als Abschnitt des Trägers betrachtet werden. Dadurch stehen der Träger und der Steckverbinder in einer definierten und unveränderlichen Lage und Ausrichtung zueinander. Die einteilige Ausbildung räumt außerdem jedes Risiko einer Verdrehung des Steckverbinders gegenüber dem Träger aus.

Der Träger stellt eine Aufnahme für die Platine bereit und fixiert mit dieser Aufnahme die Platine gegenüber dem Träger und damit auch gegenüber dem Steckverbinder in einer vorgegebenen Lage und Position.

Weiterhin sind die elektrischen Leitungen zwischen dem Steckverbinder und der Platine, die in dem Träger angeordnet ist, als metallische Leiter ausgebildet, die in dem Träger umspritzt sind. Diese metallischen Leiter ragen im Bereich des Steckverbinders und im Bereich der Platine abschnittsweise zur Kontaktierung aus dem Spritzgussteil des Trägers heraus.

Platinenseitig wird die Platine, die auf dem Träger fixiert ist, mit den herausragenden Abschnitten der elektrischen Leiter gekoppelt und auf Seiten des Steckverbinders ragen Abschnitt der elektrischen Leitungen zur Kontaktierung über einen korrespondierenden fahrzeugseitigen Steckverbinder heraus.

Die elektrischen Leitungen sind durch die Aufnahme in dem Spritzgussteil selbst isoliert und in ihrer Lage gegenüber dem Träger fixiert. Es sind keine Kabelführungen zur Verbindung des Steckverbinders und der Platine erforderlich, stattdessen dienen die im Träger umspritzten elektrischen Leitungen als elektrische Signal- und Versorgungswege.

Bei der Herstellung des Trägers in einem Spritzgussverfahren werden durch Umspritzen der elektrischen Leitungen einerseits die Lagebeziehungen zwischen Steckverbinder und Kontakten für die Platine fixiert, weiterhin die Leitungen gegeneinander und gegenüber der Umwelt isoliert und reproduzierbare Lagebeziehungen zwischen den Kontakten und der Platine bereitgestellt. Die elektrischen Leitungen können als Litzen, Bleche oder Drähte ausgebildet sein. Besonders geeignet sind gestanzte und gebogene Bleche, die mit mehreren Leitungen in einem Arbeitsschritt zu fertigen sind. Bis zum Schritt des Umspritzens können diese Leitungen mit Abstandshaltern in einer gewünschten Ausrichtung zueinander gehalten werden, bevor das Spritzgussmaterial sie in ihrer Lage fixiert. Die Abstandshalter können anschließend an ihrer Position verbleiben, soweit sie keine galvanische Kopplung der Leitungen bewirken oder mit entsprechenden Werkzeugen durchstoßen werden, so dass jede galvanische Kopplung der Leiter untereinander unterbunden wird. Der Einsatz des Trägers, der darauf aufgenommenen Platine und der elektrischen Leitungen im Träger in das Griffgehäuse erlaubt es, sowohl die Lage des Steckverbinders gegenüber dem Griffgehäuse als auch der Platine in dem Griffgehäuse reproduzierbar und mit jederzeit sicherer elektrischer Kontaktierung zu gewährleisten.

Die erfindungsgemäße Fertigung des Trägers und des integral angeformten Steckverbinders in einem Arbeitsschritt macht das Bauteil besonders kostengünstig und verringert gelichzeitig Ausschuss, da die elektrischen Leiter ohne Zwischenkontaktierung vom Steckverbinder durch den Träger bis zur Platine geführt sein können. Es ist nicht erforderlich, einen Stecker z.B. durch Löten oder crimpen an Kabel anzuschließen, die dann zur Platine führen.

In einer bevorzugten Ausführungsform der Erfindung sind die elektrischen Leitungen als gestanzte und gebogene Metallstruktur mit wenigstens zwei voneinander beabstandet verlaufenden Leiterpfaden ausgebildet.

Die Herstellung der Leitungen durch Stanzen und Biegen bringt eine selbsttragende und in sich stabile Leiterstruktur hervor, welche der Formgebung des resultierenden Spritzgussteils angepasst ist und die Ausrichtung nach erstmaligem Platzieren in einem Werkzeug für den Spritzvorgang beigehält. Durch das Stanzen und Biegen können in einem Arbeitsschritt mehrere Leiterpfade gleichzeitig gebildet werden und gleichzeitig an die Form des gebildeten Spritzgussteils angepasst werden.

Entsprechende Stanzwerkzeuge und Biegeeinrichtungen sind in der Technik verfügbar und die resultierenden elektrischen Leitungen sind regelmäßig günstiger als Litzenleitungen oder Drahtleitungen. Als Materialien kommen leitfähige Metallbleche zum Einsatz.

Erfindungsgemäß weist der Träger des Fahrzeugtürgriffes eine Aufnahme für die Platine auf, die Clip- oder Rastmittel aufweist. Die Ausstattung des Trägers mit Clip- oder Rastmitteln, welche die Platine umgreifen oder an vorgesehenen Stellen durchgreifen, erlauben eine äußerst rasche und sichere Montage der Platine am Träger. Die Rastmittel und Clips können insbesondere aus dem Spritzgussmaterial des Trägers integral mit dem Träger selbst ausgebildet sein, so dass keine weiteren Mittel zur Fixierung der Platine erforderlich sind.

Vorzugsweise ist die Platine mit einer Mehrzahl von durchgehenden Öffnungen versehen, welche die aus dem Träger herausragenden metallischen Leiter aufnehmen und kontaktieren. Die aus dem Träger herausstehenden Abschnitte der metallischen Leiter werden durch die Öffnungen der Platine geführt, wenn diese auf dem Träger platziert und dort fixiert wird. Anschließend können die metallischen Leiter mit Kontakten an den durchgehenden Öffnungen galvanisch gekoppelt werden, z. B. durch Verlöten oder Umbiegen. Auf diese Weise führen die aus dem Träger herausragenden Abschnitt der metallischen Leiter zu einer noch besser reproduzierbaren Ausrichtung der Platine auf dem Träger, da diese jederzeit so anzuordnen ist, dass die herausragenden Abschnitte der Leiter durch die zugehörigen Öffnungen ragen.

In einer bevorzugten Ausgestaltung der Erfindung weist der Träger Stützansätze auf, welche sich an der Innenseite wenigstens eines der Schalenbauteile abstützen und den Träger mit der darauf fixierten Platine im Schalenbauteil fixieren, z.B. verklemmen. Die Stützansätze sorgen dafür, dass der Träger in dem Gehäuse durch Abstützen an wenigstens einem Schalenbauteil eine spielfreie und sichere Aufnahme in reproduzierbarer Stellung findet. Außerdem können die Stützansätze für den Fall, dass sie gegenüber der Platine vom Träger vorstehen, ein Anliegen der Platine an den Griffschalen vermeiden und die Platine, beispielsweise für einen nachfolgenden Verguss der Bauteile in dem Griff, in eine vorgesehene Position bringen und dort fixieren. Die Stützansätze können zur klemmenden Arretierung des Trägers in einer Griffschale ausgebildet sein, so dass der Träger nach Eindrücken in seine Montageposition durch Klemmkräfte oder durch Einrasten der Stützansätze in zugehörigen Aufnahmen der Griffschalen festgelegt ist.

In einer bevorzugten Weiterbildung der Erfindung ist außerdem einer der metallischen Leiter in einem Abschnitt zwischen dem Steckverbinder und der Platine freigelegt, ragt also aus dem Spritzgussbauteil des Trägers heraus und kontaktiert eine Innenseite eines der Schalenbauteile. Eine solche Kontaktierung kann erwünscht sein, um beispielsweise eine galvanische Kopplung von elektronischen Komponenten auf der Platine und der Griffschale, die z. B. chromummantelt ist, herzustellen.

Im vorgenannten bevorzugten Ausführungsbeispiel kann der freigelegte metallische Leiter zur Kontaktierung einer der Griffschalen auch mit einer Feder, insbesondere einer leitfähigen Blattfeder galvanisch gekoppelt sein, so dass beim Zusammensetzen der Griffschalen die Blattfeder auf der Innenseite an einer der Griffschalen anliegt und die galvanische Kopplung herstellt.

Es ist besonders bevorzugt, dass der Träger in einem Abschnitt zwischen dem Steckverbinder und der Platine mit einem oder mehreren gewinkelten Abschnitten ausgebildet ist, so dass der Träger dort eine Wandung eines der Schalenbauteile übergreifen kann und auf der Innenseite des Schalenbauteils in das Schalenbauteil eintaucht. Eine derart gewinkelte Ausgestaltung erlaubt es, den Träger in ein Schalenbauteil einzusetzen und dort derart eintauchen zu lassen, dass der Träger mitsamt der darauf befindlichen Platine in einem vergussfähigen Hohlraum liegt. Der gewinkelte Abschnitt des Trägers übergreift dabei eine Wandung, die eine Begrenzung des Vergussraumes bildet, so dass der Verguss gewährleistet ist, gleichzeitig jedoch der Steckverbinder außerhalb des Gehäuses angeordnet ist. Der Abschnitt im Inneren des Schalenbauteils liegt dann unterhalb des Füllstands der Vergussmasse, der gewinkelte Abschnitt ragt aus der Vergussmasse heraus und übergreift die Wandung, um sich außerhalb des Schalenbauteils bis zum integral ausgebildeten Steckverbinder zu erstrecken. Die im Träger gespritzten metallischen Leiter vollziehen die gewinkelten Abschnitte mit, sind also beispielsweise durch Biegevorgänge mit entsprechenden Winkeln und Krümmungen versehen und übergreifen damit ebenfalls die seitlichen Begrenzungen der Griffschalen.

Es ist besonders bevorzugt, dass eines der Schalenbauteile des Griffgehäuses eine Aufnahme für den Steckverbinder aufweist, so dass der Steckverbinder in die Steckverbinderaufnahme einrastbar oder einclipsbar ist, wenn der Träger in das Gehäuse eingesetzt ist und dort in seiner Endlage fixiert ist.

Eine Aufnahme, die den Steckverbinder an einem der Schalenbauteile aufnimmt und fixiert ist vorteilhaft, da durch eine solche mechanische Stützung das Material des Trägers und integral ausgebildeten Steckverbinders bei dem Verbindungsvorgang mit einem fahrzeugseitigen Steckverbinder geschont wird. Außerdem baut ein solches System besonders kompakt und ist sehr lagerfreundlich, da es keine losen Steckverbinder gibt, die sich bei der Lagerung mit anderen Bauteilen verhaken oder verschlingen könnten, wenn der Griff mit anderen Bauteilen zusammengelagert wird.

Es ist besonders vorteilhaft, wenn sich der Steckverbinder in einem Gehäuseansatz erstreckt, der zur mechanischen Kopplung des Fahrzeugtürgriffes mit einem Griffträger in einem Kraftfahrzeug ausgebildet ist. Fahrzeugtürgriffe haben einen oder zwei Ansätze, die bei der Montage am Fahrzeug ein Fahrzeugblech durchgreifen und auf der Innenseite des Türbleches mit einem Griffträger oder einem sonstigen Aufbau gekoppelt werden. Ist der Steckverbinder so ausgebildet, dass er sich in einem dieser mechanischen Kopplungsabschnitte des Türgriffes erstreckt, so wird der Steckverbinder bei der Montage am Fahrzeug gleichzeitig mit dem mechanischen Kopplungsabschnitt durch das Türblech des Fahrzeuges geführt. Anschließend kann auf der Innenseite eine elektrische Kopplung zwischen dem Steckverbinder und dem Fahrzeugsystem hergestellt werden.

Die Erfindung wird nun anhand der beiliegenden Zeichnungen näher erläutert.
Figur 1a zeigt einen montierten Griff gemäß einer ersten Ausführungsform der Erfindung in einer ersten Ansicht;
Figur 1b zeigt den Griff aus Figur 1a in einer zweiten Ansicht;
Figur 2a zeigt einen teilmontierten Griff gemäß der ersten Ausführungsform mit vergossener Platine;
Figur 2b zeigt einen teilmontierten Griff gemäß der ersten Ausführungsform ohne Vergussmasse;
Figur 3a zeigt den montierten Griff gemäß der ersten Ausführungsform in einer Ansicht von oben;
Figur 3b zeigt den teilmontierten Griff gemäß der ersten Ausführungsform in einer Ansicht von oben, mit vergossener Platine;
Figur 3c zeigt den teilmontierten Griff gemäß der ersten Ausführungsform in einer Ansicht oben, ohne Vergussmasse;
Figur 4a zeigt einen in einem Griff gemäß der ersten Ausführungsform angeordneten Träger mit darauf angeordneter Platine;
Figur 4b zeigt den Träger aus Figur 4a, wobei die Platine entfernt ist;
Figur 4c zeigt den Träger aus den Figuren 4a und 4b mit gelöster Platine und separat dargestelltem gestanzten und gebogenen elektrischen Leitungen;
Figur 5a zeigt den Träger mit darauf angeordneter Platine in einer Ansicht von oben;
Figur 5b zeigt den Träger ohne darauf angeordnete Platine in einer Ansicht von oben;
Figur 5c zeigt den Träger in einer Ansicht von oben und in einer teildurchsichtigen Darstellung zur Verdeutlichung des Verlaufs der elektrischen Leitungen im Träger;
Figur 6a zeigt die gestanzten und gebogenen elektrischen Leitungen zur Umspritzung im Träger;
Figur 6b zeigt einen Teilabschnitt des im Spritzguss erstellten Trägers mit darin angeordneten elektrischen Leitungen;
Figur 6c zeigt den Träger aus Figur 6b in einer teildurchsichtigen Darstellung;
Figur 7a zeigt eine teilmontierte Darstellung des Griffes gemäß der ersten Ausführungsform mit dem vollständig im Griff montierten Träger;
Figur 7b zeigt eine Schnittansicht des Trägers aus Figur 7a zur Darstellung des in dem Griff eingeclipsten Steckverbinders;
Figur 8a zeigt den montierten Griff gemäß der ersten Ausführungsform in einer Ansicht von hinten (von Fahrzeugseite);
Figur 8b zeigt den Träger aus dem Fahrzeugtürgriff der Ansicht 8a mit darauf angeordneter Platine;
Figur 8c zeigt den Träger aus dem Fahrzeugtürgriff der Ansicht 8a ohne Platine;

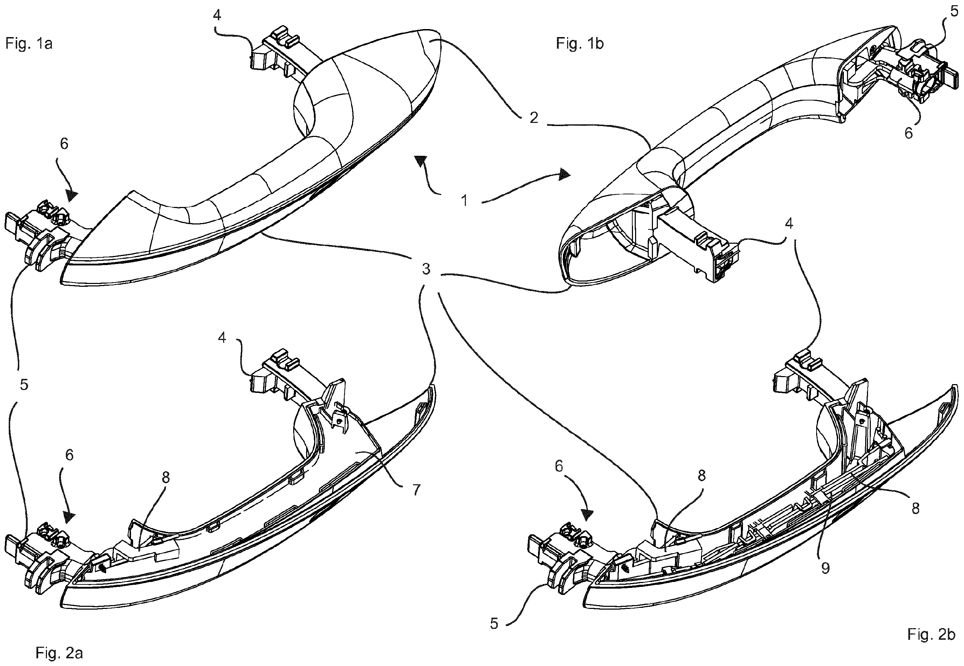

In Figur 1 ist ein Kraftfahrzeugtürgriff 1 gemäß einer ersten Ausführungsform der Erfindung gezeigt. Der Griff 1 weist ein oberes Schalenbauteil 2 und ein unteres Schalenbauteil 3 auf, die bei Montage des Griffes verbunden werden, um die Handhabe des Kraftfahrzeugtürgriffes 1 zu bilden. An den Kraftfahrzeugtürgriff 1 sind außerdem mechanische Kopplungsansätze 4 und 5 ausgebildet. Diese mechanische Kopplungsansätze 4 und 5 ragen bei der Montage des Kraftfahrzeugtürgriffes 1 durch Ausnehmungen in einem Fahrzeugtürblech und werden auf der Innenseite des Fahrzeugtürbleches mit einem Griffträger gekoppelt, so dass der Kraftfahrzeugtürgriff 1 an der Tür montiert und zur mechanischen Betätigung von fahrzeugseitigen Schließkomponenten gekoppelt ist. In dem mechanischen Kopplungsabschnitt 5 ist ein Steckverbinder 6 aufgenommen, auf den weiter unten ausführlich Bezug genommen wird.

Figur 2a zeigt den Griff aus den Figuren 1a und 1b, wobei das Schalenbauteil 2 entfernt ist. Es ist in dieser Darstellung gut erkennbar, dass die Schalenbauteile 2 und 3 einen Hohlraum begrenzen, in dem weitere Komponenten aufgenommen sind. Insbesondere ist in Figur 2a die Vergussmasse 7 dargestellt, welche den wannenförmigen Innenraum des Schalenbauteils 3 ausfüllt. Diese Vergussmasse wird flüssig in das Schalenbauteil 3 eingefüllt, um die darin befindlichen Komponenten, insbesondere den Träger 8 und eine darauf befindliche Platine 9 mit elektrischen Bauteilen schützend zu umgeben. Nach dem Aushärten sichert die Vergussmasse 7 die im Schalenbauteil 3 angeordneten Komponenten vor Witterungseinflüssen, mechanischer Beschädigung und arretiert sie in ihrer Lage. In der Figur 2a ist außerdem bereits ein Abschnitt des Trägers 8 zu sehen, der aus der Vergussmasse 7 herausragt. Der sichtbare Abschnitt des Trägers 8 übergreift eine Wandung des Schalenbauteils 3 mit einem gewinkelten Abschnitt. Auf diese Weise ist es möglich, die Wandung für den Verguss in dem Schalenbauteil 3 höher auszuführen, da der Träger 8 durch gewinkelte Abschnitte die Wandung übergreift.

In Figur 2b wurde aus der Darstellung der Figur 2a die Vergussmasse 7 entfernt, so dass die im Schalenbauteil 3 angeordneten Komponenten sichtbar sind. Der Träger 8 mit einer darauf angeordneten Platine 9 ist in dem Schalenbauteil 3 aufgenommen. Der Träger 8 stützt sich auf der Innenseite des Schalenbauteils 3 an dessen Wandungen ab, so dass der Träger 8 in seiner Lage im Schalenbauteil 3 festgelegt ist.

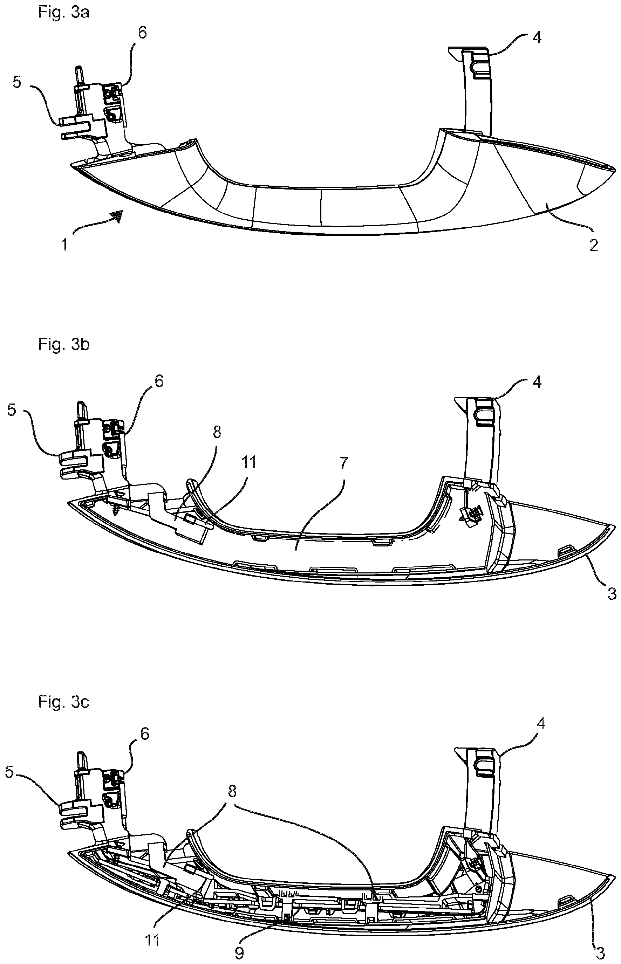

Die Figuren 3a, 3b und 3c zeigen zu den Figuren 1a, 2a, 2b korrespondierende Darstellungen, allerdings in einer anderen Ansicht. In Figur 3a ist der Kraftfahrzeugtürgriff 1 in einer geschlossenen und vollständig montierten Form dargestellt, also mit aufgesetztem Schalenbauteil 2. In den Figuren 3b und 3c ist das Schalenbauteil 2 entfernt, so dass das untere Schalenbauteil 3 offenliegt. In Figur 3b ist der Innenraum des Schalenbauteils 3 wiederum mit der Vergussmasse 7 gefüllt, wobei der Träger 8 abschnittsweise aus der Vergussmasse 7 herausragt und eine Wandung des Schalenbauteils 3 übergreift und sich bis zum Steckverbinder 6 erstreckt, mit dem er integral ausgebildet ist. Figur 3c zeigt diese Ansicht, jedoch ohne die Vergussmasse 7.

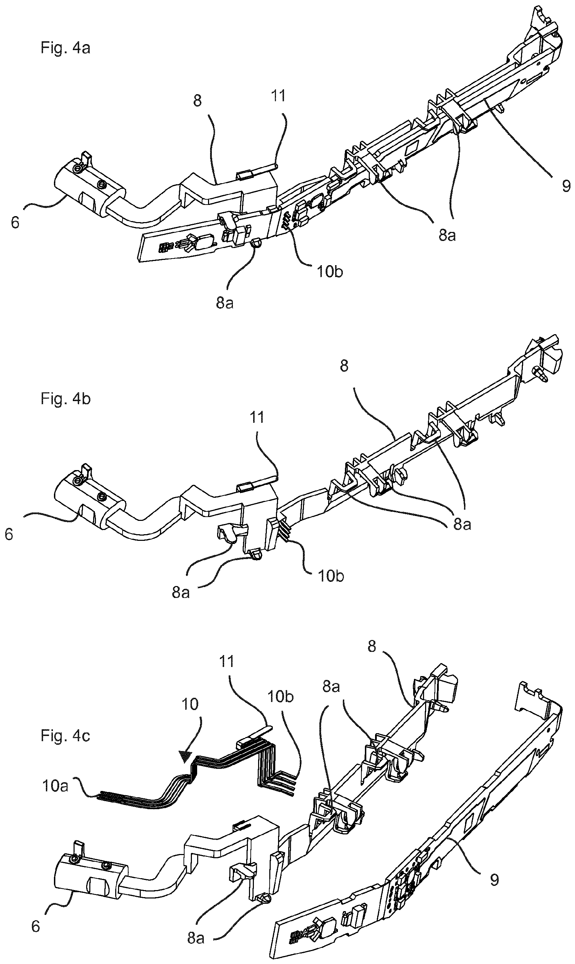

Die Figur 4a zeigt den Träger 8 in Alleinstellung, der aus einem Spritzgussmaterial gefertigt ist und einem integral angeformten Steckverbinder 6 aufweist. Die Platine 9 ist mit Haltemitteln 8a, die integral mit dem Träger 8 ausgebildet sind, gehalten. In dem Träger 8 erstrecken sich von dem Steckverbinder 6 bis zu der Platine 9 elektrische Leitungen 10, die im Bereich der Platine mit Abschnitten 10b aus dem Träger 8 herausragen und durch Ausnehmungen in der Platine 9 geführt sind. Dort sind sie zur Kontaktierung der Platine 9 galvanisch mit entsprechenden Kontakten an den Durchführungen verbunden. Im Bereich des Steckverbinders 6 ragen Abschnitte 10a in dem Steckverbinder zur Kontaktierung heraus.

In Figur 4b sind sowohl die als Clips ausgeführten Haltemittel 8a an dem Träger 8 deutlicher zu erkennen, also auch die Endabschnitte 10b der elektrischen Leitungen 10, da in dieser Darstellung die Platine 9 entfernt wurde.

In Figur 4c ist der Träger 8 mit dem integral angeformten Steckverbinder 6 gezeigt, außerdem sind die elektrischen Leitungen 10 zur Verdeutlichung aus dem Inneren des Trägers 8 verschoben. Es ist ersichtlich, dass die Leitungen 10 als beabstandet zueinander verlaufende gestanzte und gebogene elektrische Bleche ausgeführt sind, welche die äußere Form des spritzgegossenen Trägers 8 nachvollziehen. Insbesondere weisen die elektrischen Leitungen 10 in ihrer gestanzten und gebogenen Form dieselben Winkelungen auf, die es dem Träger 8 ermöglichen, abschnittsweise in das Schalenbauteil 3 versenkt zu werden und es im Bereich seiner Wandung zu übergreifen, so dass der angeformte Steckverbinder 6 in den mechanischen Kopplungsansatz 5 aufgenommen werden kann. In dieser Darstellung ist auch ersichtlich, dass eine der Leiterbahnen der elektrischen Leitungen 10 von der Platine aus nicht bis zum Steckverbinder 6 geführt wird, sondern in einem Abschnitt zwischen Steckverbinder 6 und Platine 9 mit einer Blattfeder 11 gekoppelt ist. Diese Blattfeder ist auf der Oberseite des Trägers 8 nach außen geführt und kontaktiert dort die Innenseite des Schalenbauteils 2, wenn dieses zum Verschluss des Griffes aufgelegt wird. Damit ist die Innenseite des Schalenbauteils 2, welches insbesondere eine Verchromung aufweisen kann, mit der Platine 9 durch die elektrischen Leitungen 10 gekoppelt.

In diesem Ausführungsbeispiel sind die elektrischen Leitungen 10 durch Stanzen und Biegen als selbsttragende Mehrzahl von beabstandet und parallel verlaufenden Leiterpfaden gebildet. Diese Anordnung von Leitern kann in einer Spritzform angeordnet werden, in der durch Umspritzen der Träger 8 mit dem Steckverbinder 6 gebildet wird, wobei im Bereich des Steckverbinders 6 und im Bereich der Platine die elektrischen Leitungen 10 mit den Abschnitten 10a, 10b aus dem Werkzeug herausragen und nicht umspritzt werden.

Für den Vorgang des Umspritzens können die Leitungen durch nicht-leitende Abstandshalter in korrekter Ausrichtung zueinander gehalten werden. Alternativ können die elektrischen Leitungen 10 vor dem Umspritzvorgang auch durch leitfähige Abstandshalter verbunden sein, die nach dem Umspritzvorgang durch ein entsprechendes Werkzeug getrennt werden.

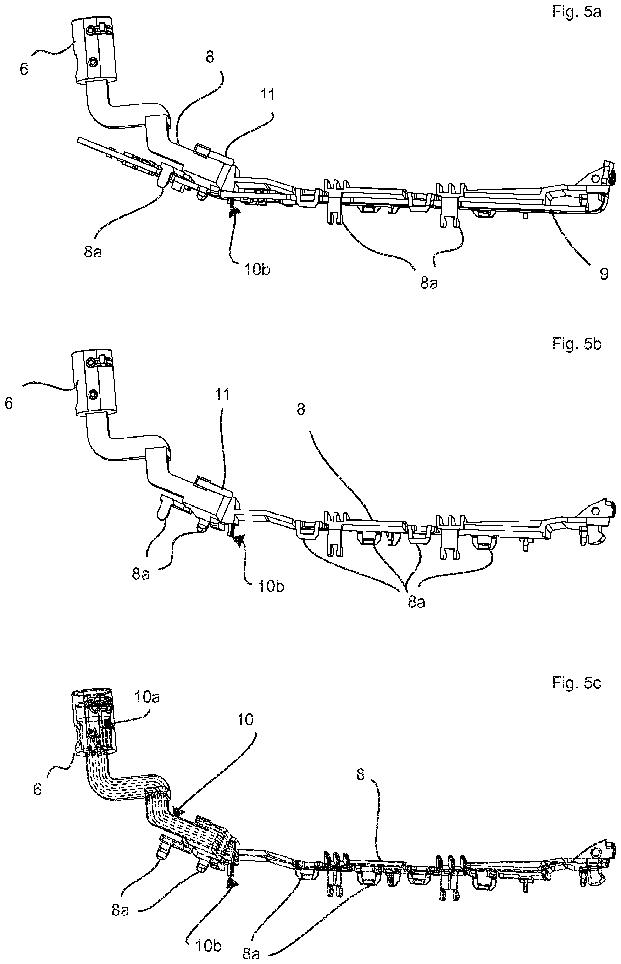

Die Figuren 5a, 5b und 5c korrespondieren mit den Darstellungen 4a und 4b, zeigen jedoch den Träger 8 und die Platine 9 aus einer Ansicht von oben. In Figur 5c ist der Träger 8 mit seinem Spritzgussmaterial teildurchsichtig dargestellt, so dass der Verlauf der elektrischen Kontakte 10 durch das Spritzgussmaterial von dem Steckverbinder 6 ausgehend bis zur Seite der Platine nachvollziehbar dargestellt ist.

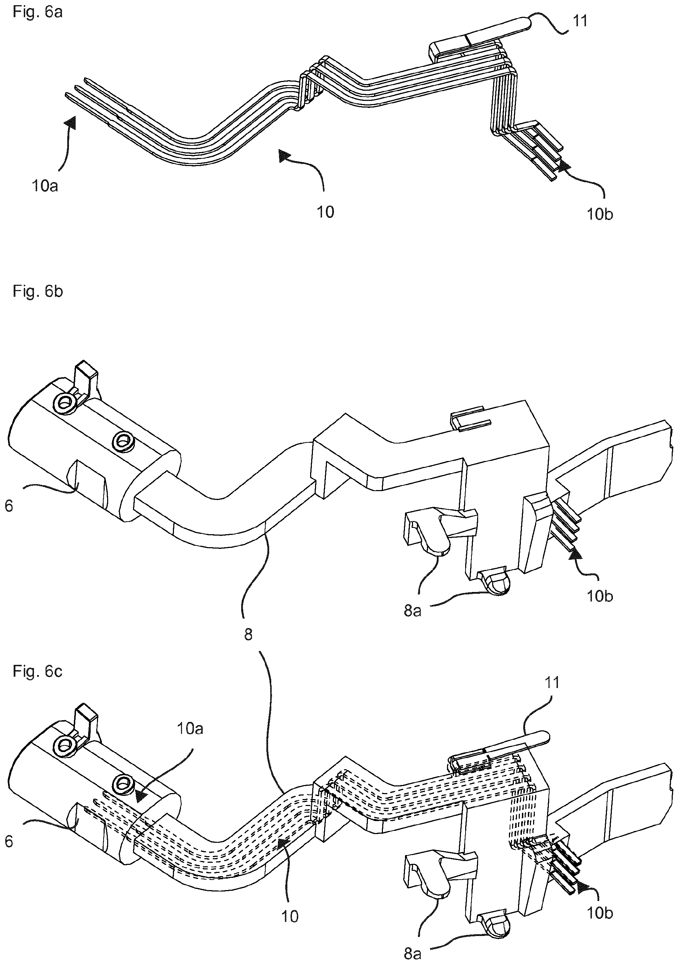

Die Figuren 6a, 6b und 6c zeigen die Vergrößerungen des Trägerabschnittes und der zugehörigen elektrischen Leitungen in dem Bereich, in dem sich die elektrischen Leitungen 10 durch den Träger 8 erstrecken.

Figur 6a zeigt die isolierten elektrischen Leitungen 10 mit der angekoppelten Blattfeder 11, wie sie zur Aufnahme in dem Träger 8 ausgebildet sind. Endseitig sind jeweils Kontaktanschlüsse 10a, 10b angeformt, die einerseits in dem Steckverbinder 6 zur Kontaktierung aus dem Spritzgussteil des Trägers 8 herausgeführt sind und auf der anderen Endseite aus dem Träger 8 herausstehen, um die Platine 9 zu kontaktieren. Figur 6c zeigt den Träger 8 mit eingegossenen elektrischen Leitungen 10, wobei die elektrischen Leitungen 10 in den Bereichen, die von dem Material des Trägers 8 umschlossen sind, gestrichelt dargestellt sind. In dieser Darstellung ist der Verlauf der elektrischen Leitungen in dem Spritzgusskörper zu erkennen. In dieser Darstellung ist nicht ohne weiteres zu erkennen, dass der Steckverbinder 6 als Hohlkörper mit einem für die Aufnahme eines komplementären Steckers freien Innenraum ausgebildet ist, so dass die Anschlüsse 10a der elektrischen Leitungen 10 im Inneren des Steckverbinders 6 kontaktierbar freiliegen.

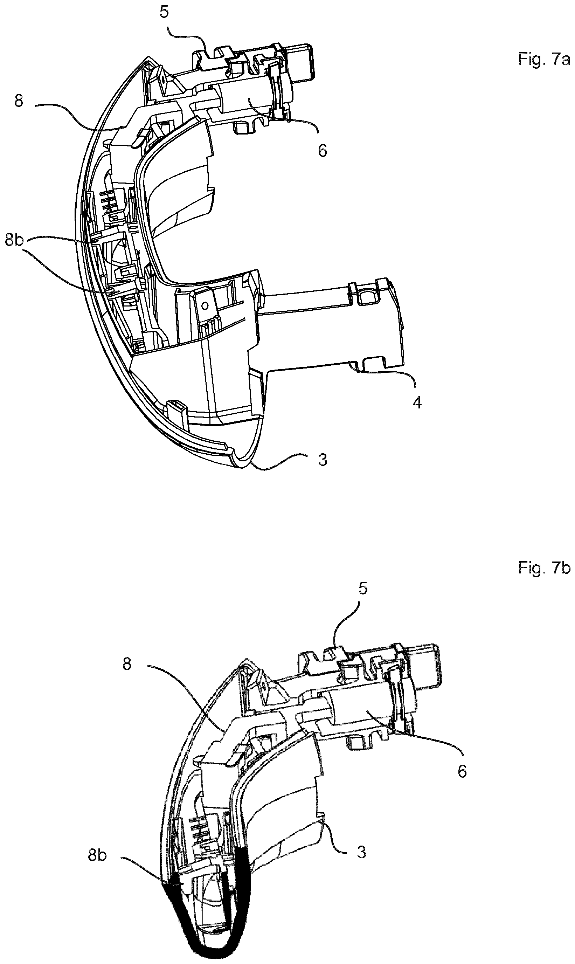

Die Figur 7a zeigt ebenso wie die Schnittdarstellung in Figur 7b den Griff gemäß dem ersten Ausführungsbeispiel mit abgenommenem Schalenbauteil 2, um die Anordnung des Trägers 8 und des integral ausgebildeten Steckverbinders 6 im Griff darzustellen. Es ist zu erkennen, dass der Steckverbinder 6 in eine Ausnehmung des Griffes, insbesondere in einem Freiraum des mechanisch Kopplungsteils 5 seitlich eingeschoben ist und dort zur Steckkontaktierung zur Verfügung steht. Außerdem ist in Figur 7b zu erkennen, dass die Stützansätze 8b sich innen an der Wandung des Schalenbauteils 3 abstützen, um eine sichere Lage des Trägers in dem Schalenbauteil 3 zu gewährleisten, bis der Verguss der Komponenten in dem Schalenbauteil 3 stattgefunden hat.

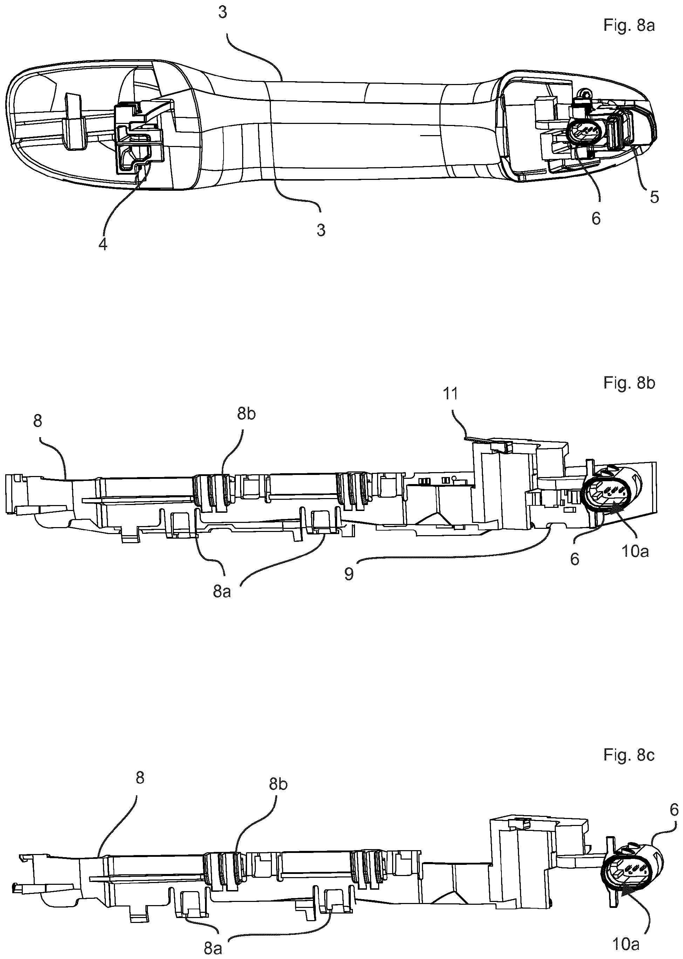

Die Figuren 8a, 8b und 8c zeigen schließlich die erfindungsgemäße erste Ausführungsform in einer weiteren Ansicht, welche den montierten Griff in Figur 8a zeigt. Die Figur 8b zeigt den Träger 8 mit integral angeformtem Steckverbinder 6, wobei in dieser Darstellung die freiliegenden Kontaktabschnitte 10a im Steckverbinder 6 sichtbar sind. Figur 8b zeigt den Träger mit darauf angeclipster Platine. Die Figur 8c schließlich zeigt den Träger ohne angeclipste Platine.

## Patentansprüche

1. Fahrzeugtürgriff (1) mit einem Griffgehäuse, wobei das Griffgehäuse aus wenigstens zwei Schalenbauteilen (2, 3) gebildet ist,
mit wenigstens einer Platine (9), welche mit elektronischen Bauteilen bestückt und in dem Griffgehäuse aufgenommen ist,
mit wenigstens einem Steckverbinder (6), welcher zur Kontaktierung der Platine (9) außerhalb des Gehäuses angeordnet ist, wobei der Steckverbinder (6) eine Mehrzahl von Kontakten (10a) aufweist, welche mit elektrischen Leitungen gekoppelt sind, die sich in das Gehäuse und bis zur Platine (9) erstrecken, wobei
die Platine (9) auf einem Träger (8) in dem Griffgehäuse angeordnet und fixiert ist, wobei der Träger (8) mit dem Steckverbinder (6) als Spritzgussteil einteilig ausgebildet ist und wobei die elektrischen Leitungen in dem Träger (8) als metallische Leiter (10) umspritzt sind und wenigstens einige der metallischen Leiter (10) im Bereich des Steckverbinders (6) und der Platine (9) zur Kontaktierung aus dem Spritzgussteil herausragen,
**dadurch gekennzeichnet,**
**dass** der Träger (8) eine Aufnahme (8a) für die Platine (9) aufweist, welche die Platine mit Clip- oder Rastmitteln am Träger hält.

2. Fahrzeugtürgriff nach Anspruch 1, wobei die elektrischen Leitungen (10) als gestanzte und gebogene Metallstruktur mit wenigstens zwei beabstandet voneinander verlaufenden Leiterpfaden gebildet sind.

3. Fahrzeugtürgriff nach einem der vorangehenden Ansprüche, wobei die Platine (9) eine Mehrzahl von durchgehenden Öffnungen aufweist, welche die aus dem Träger herausragenden metallischen Leiter (10b) aufnehmen und kontaktieren.

4. Fahrzeugtürgriff nach einem der vorangehenden Ansprüche, wobei der Träger (8) Stützansätze (8b) aufweist, welche sich an der Innenseite wenigstens eines der Schalenbauteile (3) abstützen und den Träger (8) mit der Platine (9) im Schalenbauteil (3) fixieren.

5. Fahrzeugtürgriff nach einem der vorangehenden Ansprüche, wobei wenigstens einer der metallischen Leiter (10b) aus dem Träger (8) in einem Abschnitt zwischen dem Steckverbinder (6) und der Platine (9) herausragt und eine Innenseite eines der Schalenbauteile (2, 3) kontaktiert.

6. Fahrzeugtürgriff nach Anspruch 5, wobei mit dem metallischen Leiter zur Kontaktierung der Innenseite eines der Schalenbauteile eine leitfähige Blattfeder (11) galvanisch gekoppelt ist.

7. Fahrzeugtürgriff nach einem der vorangehenden Ansprüche, wobei der Träger (8) in einem Abschnitt zwischen dem Steckverbinder (6) und der Platine (9) einen gewinkelten Abschnitt aufweist, so dass der Träger (8) mit dem gewinkelten Abschnitt eine Wandung eines Schalenbauteils (3) übergreift und aus einer Seite der Wandung in das Schalenbauteil (3) eintaucht.

8. Fahrzeugtürgriff nach einem der vorangehenden Ansprüche, wobei eines der Schalenbauteile (3) eine Aufnahme für den Steckverbinder (6) aufweist, wobei der Steckverbinder (6) in die Steckverbinder-Aufnahme eingerastet oder eingeklipst ist, wenn der Träger (8) in das Gehäuse eingesetzt ist.

9. Fahrzeugtürgriff nach einem der vorangehenden Ansprüche, wobei der Steckverbinder (6) sich in einem Gehäuseansatz (5) zur mechanischen Kopplung des Fahrzeugtürgriffes mit einem Griffträger in einem Kraftfahrzeug erstreckt.

## Claims

1. Vehicle door handle (1) having a handle housing, wherein the handle housing is formed from at least two shell components (2, 3),
with at least one circuit board (9) which is equipped with electronic components and is accommodated in the handle housing,
with at least one plug-in connector (6) which is arranged outside the housing so as to make contact with the circuit board (9), wherein the plug-in connector (6) has a plurality of contacts (10a) which are connected to electrical lines that extend into the housing and as far as the circuit board (9), wherein the circuit board (9) is situated on and affixed to a support (8) in the handle housing, wherein the support (8) is constructed integrally with the plug-in connector (6) as an injection-moulded part and wherein the electrical lines are overmoulded in the support (8) as metal conductors (10) and at least some of the metal conductors (10) protrude out of the injection-moulded part in the region of the plug-in connector (6) and the circuit board (9) for the purpose of making contact,
**characterized in that**
the support (8) has a retaining element (8a) for the circuit board (9), which holds the circuit board on the support with clipping or detent means.

2. Vehicle door handle according to Claim 1, wherein the electrical lines (10) are formed as a stamped and bent metal structure having at least two conductor paths extending at a distance from each other.

3. Vehicle door handle according to any one of the preceding claims, wherein the circuit board (9) has a plurality of through holes which receive and make contact with the metal conductors (10b) protruding from the support.

4. Vehicle door handle according to any one of the preceding claims, wherein the support (8) has support lugs (8b), which are braced against the inside of at least one of the shell components (3) and fix the support (8) with the circuit board (9) in the shell component (3).

5. Vehicle door handle according to any one of the preceding claims, wherein at least one of the metal conductors (10b) protrudes from the support (8) in a section between the plug-in connector (6) and the circuit board (9) and contacts an inner side of one of the shell components (2, 3).

6. Vehicle door handle according to Claim 5, wherein a conductive leaf spring (11) is galvanically coupled with the metal conductor to make contact with the inside of one of the shell components.

7. Vehicle door handle according to any one of the preceding claims, wherein the support (8) has an angled portion in a section between the plug-in connector (6) and the circuit board (9), so that the support (8) overlaps a wall of a shell component (3) with the angle portion and advances into the shell component (3) from one side of the wall.

8. Vehicle door handle according to any one of the preceding claims, wherein one of the shell components (3) has a receptacle for the plug-in connector (6), wherein the plug-in connector (6) is snapped or clipped into the connector receptacle when the support (8) is inserted in the housing.

9. Vehicle door handle according to any one of the preceding claims, wherein the plug-in connector (6) extends in a housing fitting (5) for mechanical coupling of the vehicle door handle with a handle support in a motor vehicle.

## Revendications

1. Poignée de porte de véhicule automobile (1) avec un boîtier de poignée, sachant que le boîtier de poignée est composé d'au moins deux composants de coque (2, 3), avec au moins une platine (9), laquelle est équipée de composants électroniques et est logée dans le boîtier de poignée,
avec au moins un connecteur (6), lequel est disposé pour mettre en contact la platine (9) en dehors du boîtier, sachant que le connecteur (6) comporte une pluralité de contacts (10a), lesquels sont couplés à des conduits électriques, qui s'étendent dans le boîtier et jusqu'à la platine (9), sachant que
la platine (9) est disposée et fixée sur un support (8) dans le boîtier de poignée, sachant que le support (8) est constitué en une pièce avec le connecteur (6) sous la forme d'une pièce moulée par injection et sachant que les conduits électriques dans le support (8) sont enrobés par extrusion en tant que conducteurs métalliques (10) et qu'au moins plusieurs des conducteurs métalliques (10) à proximité du connecteur (6) et de la platine (9) font saillie de la pièce moulée par injection pour la mise en contact
**caractérisé en ce que**
le support (8) comporte un logement (8a) pour la platine (9), lequel maintient la platine sur le support avec des moyens de pinçage et d'encliquetage.

2. Poignée de porte de véhicule automobile selon la revendication 1, sachant que les conduits électriques (10) sont formés sous la forme d'une structure métallique estampée et pliée avec au moins deux chemins de conducteurs passant à distance l'un de l'autre.

3. Poignée de porte de véhicule automobile selon l'une quelconque des revendications précédentes, sachant que la platine (9) comporte une pluralité d'ouvertures continues, lesquelles logent et mettent en contact les conducteurs métalliques (10b) dépassant du support.

4. Poignée de porte de véhicule automobile selon l'une quelconque des revendications précédentes, sachant que le support (8) comporte des saillies de soutien (8b), lesquelles s'appuient sur la face intérieure d'au moins un des composants de coque (3) et fixent le support (8) avec la platine (9) dans le composant de coque (3).

5. Poignée de porte de véhicule automobile selon l'une quelconque des revendications précédentes, sachant qu'au moins un des conducteurs métalliques (10b) fait saillie du support (8) dans une section entre le connecteur (6) et la platine (9) et fait contact avec une face intérieure d'un des composants de coque (2, 3) .

6. Poignée de porte de véhicule automobile selon la revendication 5, sachant qu'un ressort à lame (11) est galvaniquement couplé au conducteur métallique pour la mise en contact de la face intérieure d'un des composants de coque.

7. Poignée de porte de véhicule automobile selon l'une quelconque des revendications précédentes, sachant que le support (8) comporte une section coudée dans une section entre le connecteur (6) et la platine (9) de telle manière que le support (8) vient en prise avec la section coudée sur une paroi d'un composant de coque (3) et plonge dans le composant de coque (3) depuis un côté de la paroi.

8. Poignée de porte de véhicule automobile selon l'une quelconque des revendications précédentes, sachant qu'un des composants de coque (3) comporte un logement pour le connecteur (6), sachant que le connecteur (6) est encliqueté ou pincé dans le logement de connecteur, lorsque le support (8) est inséré dans le boîtier.

9. Poignée de porte de véhicule automobile selon l'une quelconque des revendications précédentes, sachant que le connecteur (6) s'étend dans un embout de boîtier (5) pour le couplage mécanique de la poignée de porte de véhicule automobile avec un support de poignée dans un véhicule automobile.
